# FASCICULE DE BREVET EUROPEEN

(11) **EP 3 040 710 B1**
(45) Date de publication et mention de la délivrance du brevet: **05.08.2020**
(21) Numéro de dépôt: 16150012.9
(22) Date de dépôt: 04.01.2016
(51) Int. Cl.: G01N 21/65, G01J 3/44, B82Y 15/00, B82Y 20/00, B82Y 30/00

(54) **PROCEDE DE FABRICATION D'UN SUBSTRAT POUR DIFFUSION RAMAN EXALTEE DE SURFACE**
HERSTELLUNGSVERFAHREN EINES SUBSTRATS ZUR VERSTÄRKTEN RAMAN-STREUUNG AN DER OBERFLÄCHE
METHOD FOR MANUFACTURING A SUBSTRATE FOR SURFACE-ENHANCED RAMAN SCATTERING

(30) Priorité: 05.01.2015 FR 1550009
(43) Date de publication de la demande: 06.07.2016
(73) Titulaire: Commissariat à l'Energie Atomique et aux Energies Alternatives, 75015 Paris (FR)
(72) Inventeur: LANDIS, Stefan, 38210 Tullins (FR); REBOUD, Vincent, 75013 Paris (FR)
(74) Mandataire: Cabinet Camus Lebkiri

(56) Documents cités:
- US-A1- 2011 140 209
- US-A1- 2013 038 870
- DATABASE WPI Week 201172 31 août 2011 (2011-08-31) Thomson Scientific, London, GB; AN 2011-L83460 XP002751435, -& KR 2011 0097354 A (KOREA ADV INST SCI&TECHNOLOGY) 31 août 2011 (2011-08-31)
- HYUNGSOON IM ET AL: "Vertically Oriented Sub-10-nm Plasmonic Nanogap Arrays", NANO LETTERS, vol. 10, no. 6, 9 juin 2010 (2010-06-09), pages 2231-2236, XP055229630, US ISSN: 1530-6984, DOI: 10.1021/nl1012085

## Description

### DOMAINE TECHNIQUE

Le domaine de l'invention est celui des procédés de fabrication de substrats pouvant être utilisés pour mettre en œuvre des procédés de diffusion Raman exaltée de surface (SERS). L'invention concerne également un substrat pour diffusion Raman exaltée de surface.

### ETAT DE LA TECHNIQUE ANTERIEUR

La diffusion Raman exaltée de surface (SERS) est l'une des techniques de détection les plus prometteuses pour identifier et caractériser des molécules. Cette technique consiste à déposer les molécules d'intérêt sur un substrat présentant une surface métallique rugueuse. La surface métallique sur laquelle sont fixées les molécules d'intérêt est ensuite éclairée par une lumière monochromatique. Les molécules émettent alors un signal Raman caractéristique de ces molécules, ce qui les rend détectables et identifiables.

Toutefois le signal Raman émis par les molécules présente une intensité très inférieure à l'intensité de la lumière monochromatique avec laquelle on a éclairé les molécules.

Pour remédier à ce problème, on a constaté que la rugosité de la surface métallique du substrat qui porte les molécules d'intérêt permet d'exalter le signal Raman émis par les molécules d'intérêt grâce à l'excitation de plasmons localisés du métal (exaltation par effet électromagnétique) et par transfert de charges entre le métal et la molécule adsorbée (effet chimique). Cette exaltation permet ainsi de détecter spécifiquement des échantillons adsorbés avec des concentrations extrêmement faibles et/ou sur des temps très courts.

Cette exaltation peut se faire grâce à des « points chauds » (« hot spots » en anglais).

Ces points chauds sont des zones du substrat au niveau desquelles le champ électromagnétique est localisé et intense. Pour cela, les points chauds présentent généralement des dimensions inférieures à la longueur d'onde de la lumière monochromatique.

L'art antérieur connait ainsi des procédés permettant de réaliser des points chauds en surface d'un substrat. Ces points chauds peuvent être formés par des cavités ou par des effets de pointe. Ainsi, le document Appl. Phys. Lett. 97, 063106 2010, Nanoletters, 9, 4505, 2009 décrit des points chauds formés par des pointes. Le document Nano Lett. 11 , 2538, 2011 ; J. Vac. Sci. Technol. B 27, 2640 (2009) décrit quant à lui des points chauds formés par des cavités.

Le document KR 2011 0097354 A décrit une structure SERS à nanoespace multicouche. La structure a des couches sacrificielles et des couches de renfort déposées sur un substrat. Des nanoespaces sont formées en retirant la région de la couche sacrificielle entre les couches de renfort.

Toutefois, les méthodes de formation des points chauds de l'art antérieur utilisent des technologies de structuration pouvant atteindre de très hautes résolutions spatiales et elles sont donc complexes et très couteuses. En outre, elles ne permettent généralement pas de produire des substrats présentant une forte densité de points chauds, de sorte que l'augmentation de l'intensité lumineuse émise par les molécules d'intérêt est limitée.

### EXPOSE DE L'INVENTION

L'invention vise à remédier aux inconvénients de l'état de la technique en proposant un procédé de fabrication d'un substrat pour diffusion Raman exaltée de surface qui ne soit pas agressif, qui soit simple à mettre en œuvre, et qui permette une augmentation constante de l'intensité lumineuse émise par les molécules sur l'ensemble du substrat.

Un autre objet de l'invention est de proposer un procédé de fabrication d'un substrat pour diffusion Raman exaltée de surface qui soit reproductible et fiable, qui permette une forte augmentation de l'intensité lumineuse émise par les molécules d'intérêt et qui présente une forte densité de points chauds.

Un autre objet de l'invention est de proposer un procédé de fabrication d'un substrat pour diffusion Raman exaltée de surface qui permette de réaliser simultanément un grand nombre de substrats identiques.

Pour ce faire, un premier aspect de l'invention concerne un procédé de fabrication d'un substrat pour diffusion Raman exaltée de surface, le procédé comportant les étapes suivantes :
- (a) réalisation d'une structure porteuse non métallique sur une surface supérieure d'un support, la structure porteuse comportant au moins un motif microstructuré, le motif microstructuré comportant un sommet et des parois latérales, les parois latérales s'étendant suivant une direction sécante à la direction de la surface supérieure;
- (b) dépôt d'une multicouche sur la structure porteuse, la multicouche comportant au moins deux couches métalliques de même épaisseur et une couche intercalaire disposée entre les deux couches métalliques, chaque couche intercalaire étant réalisée dans un matériau pouvant être gravé sélectivement par rapport aux couches métalliques;
- (c) gravure par polissage mécano chimique d'une partie de la multicouche déposée sur le sommet du motif microstructuré de façon à exposer des extrémités de chaque couche de la multicouche;
- (d) gravure sélective des extrémités des couches intercalaires de façon à former des cavités entre les extrémités de deux couches métalliques successives.

Ainsi, le procédé on réalise tout d'abord une structure porteuse dont les dimensions, typiquement comprises entre 50 nm et 100 µm, ne permettent pas directement d'obtenir la fonction d'exaltation du champ électromagnétique, mais qui est facile à réaliser par les techniques connues. Sur cette structure porteuse, on réalise d'autres structures avec des dimensions caractéristiques bien plus faibles qui cette fois permettent d'exalter le champ électromagnétique. Ces secondes structures sont réalisées par dépôts successifs de couches métalliques et de couches intercalaires de façon à former une multicouche qui épouse la forme de la structure porteuse. La réponse du substrat SERS ainsi formé est parfaitement prédictible grâce à la réalisation de nanogaps séparés par des couches métalliques d'épaisseur constante sur une structure porteuse non métallique, qui ne participe donc pas à l'effet SERS. On réalise ensuite localement un écrêtage de la partie de la multicouche déposée sur la partie supérieure de chaque motif de la structure porteuse. Le fait d'écrêter la partie de la multicouche par polissage mécano chimique permet de garantir la conservation de l'épaisseur des couches de la multicouche en utilisant un procédé de gravure parfaitement anisotrope, qui n'arrondit pas les angles. On obtient ainsi un substrat SERS dont la réponse est parfaitement contrôlée et prédictible. Suite à l'étape d'écrêtage, l'alternance des couches de la multicouche est alors exposée à l'air de sorte que l'on a accès à chacune des couches de la multicouche. On peut alors graver sélectivement et partiellement les couches intercalaires de la multicouche de façon à former des cavités entre les extrémités de deux couches métalliques successives. Le procédé permet donc d'obtenir des motifs micrométriques entourés par des picots métalliques de dimensions nanométriques parfaitement contrôlées et reproductibles, séparés entre deux par des cavités de dimensions nanométriques également parfaitement contrôlées et reproductibles.

Le procédé est particulièrement avantageux car il permet de réaliser facilement des picots métalliques de dimensions nanométriques séparés par des cavités de dimensions nanométriques sans avoir recourt à des procédés de gravure agressifs. En outre, la largeur des picots et des cavités est très bien contrôlée et reproductible puisqu'elle est déterminée par l'épaisseur des couches déposées et qu'elle n'est pas altérée par la gravure de la partie de la multicouche déposée sur le sommet du motif microstructuré. Cette épaisseur est facile à contrôler.

Le procédé permet donc d'obtenir facilement un substrat permettant un renforcement du champ électromagnétique dont la réponse est prédictible. L'intensité du champ électromagnétique obtenu grâce au substrat ainsi formé peut ainsi être entre 10 fois et plusieurs milliers de fois supérieure à celle obtenue avec les substrats de l'art antérieur.

Dans le cadre des revendications annexées, le procédé selon l'invention peut également présenter une ou plusieurs des caractéristiques ci-après prises individuellement ou selon toutes les combinaisons techniquement possibles.

Avantageusement, la couche intercalaire est une couche diélectrique, car les couches diélectriques n'absorbent pas ou peu le plasmon généré à la surface du métal. Le substrat ainsi réalisé permettra donc une meilleure exaltation de surface. En outre, les couches diélectriques peuvent être facilement gravées de manière sélective par rapport aux couches métalliques, ce qui est avantageux lors de l'étape (d) du procédé. Avantageusement, chaque motif microstructuré présente une hauteur comprise entre 50 nm et 100 µm, ce qui permet de fabriquer facilement le motif microstructuré avec les procédés connus.

Avantageusement, chaque couche métallique de la multicouche présente une épaisseur comprise entre 1 angström et 50 nm. L'épaisseur des couches métalliques de la multicouche conditionnera la largeur des picots métalliques à la surface du substrat.

Avantageusement, chaque couche intercalaire de la multicouche présente une épaisseur comprise entre 1 angström et 20 nm. L'épaisseur des couches intercalaires conditionnera la largeur des cavités entre les picots métalliques.

Avantageusement, la multicouche présente une épaisseur inférieure à la hauteur du motif microstructuré, ce qui permet de mettre à jour toutes les couches lors de l'étape (c) d'écrêtage.

Avantageusement, les couches de la multicouche sont déposées suivant une technique de dépôt conforme, ce qui permet d'avoir une multicouche d'épaisseur constante sur l'ensemble de la surface de chaque motif microstructuré. L'étape (c) de gravure en est alors facilitée.

Avantageusement, les parois latérales du motif microstructuré s'étendent suivant une direction qui forme un angle strictement inférieur à 90° avec une direction normale à la surface supérieure du support, ce qui permet de réaliser plus facilement des dépôts conformes sur le motif.

Un deuxième aspect de l'invention concerne un substrat pour diffusion Raman exaltée de surface comportant :
- un support comportant une surface supérieure;
- une structure porteuse non métallique disposée sur la surface supérieure du support, la structure porteuse comportant au moins un motif microstructuré, le motif microstructuré comportant un sommet et des parois latérales, les parois latérales s'étendant suivant une direction sécante à la direction de la surface supérieure ;
- une multicouche disposée sur les parois latérales du motif microstructuré, la multicouche comportant au moins deux couches métalliques de même épaisseur et une couche intercalaire disposée entre les deux couches métalliques, la couche intercalaire étant réalisée dans un matériau pouvant être gravé sélectivement par rapport aux couches métalliques, chaque couche métallique comportant une extrémité, la couche intercalaire présentant une extrémité en retrait par rapport à l'extrémité des couches métalliques qui l'entourent de sorte que les extrémités de deux couches métalliques successives forment des picots métalliques séparés par un cavité.

Un tel substrat comporte de multiples points chauds au niveau des cavités situées entre les extrémités des couches métalliques, ce qui permet d'exalter fortement le signal Raman émis par les molécules d'intérêt déposées sur ce substrat grâce à l'excitation de plasmons localisés du métal (exaltation par effet électromagnétique). Un tel substrat permet donc d'augmenter l'intensité lumineuse émise par des molécules d'intérêt qui sont déposées à sa surface de sorte qu'il permet une détection plus rapide de ces molécules d'intérêt.

Dans le cadre des revendications annexées, le substrat selon le deuxième aspect de l'invention peut présenter une ou plusieurs des caractéristiques ci-après prises individuellement ou selon toutes les combinaisons techniquement possibles.

Avantageusement, la paroi latérale du motif microstructuré comporte des faces séparées par des arêtes, ce qui permet de créer un renforcement du champ électromagnétique par effet de pointe et donc d'augmenter l'exaltation du signal Raman émis par les molécules.

Avantageusement, la structure porteuse comporte plusieurs motifs microstructurés formant un réseau périodique, ce qui permet d'augmenter la densité de points chauds à la surface du substrat, et d'homogénéiser leur répartition sur le substrat. L'exaltation du signal Raman générée par le substrat est ainsi plus importante et plus homogène.

Avantageusement, les couches métalliques présentent des épaisseurs différentes les unes des autres, ce qui permet d'obtenir un gradient d'indice progressif de sorte que le substrat présentera alors des résonnances à plusieurs longueurs d'ondes incidentes.

Avantageusement, la multicouche comporte plusieurs couches intercalaires, les couches intercalaires présentant des épaisseurs différentes les unes des autres, ce qui permet d'obtenir un gradient d'indice progressif de sorte que le substrat présentera alors des résonnances à plusieurs longueurs d'ondes incidentes.

Aantageusement, chaque motif microstructuré présente une hauteur comprise entre 50 nm et 100 µm.

Avantageusement, chaque couche métallique de la multicouche présente une épaisseur comprise entre 1 angström et 50 nm, de préférence entre 10 nm et 50 nm.

Avantageusement, chaque couche intercalaire de la multicouche présente une épaisseur comprise entre 1 angström et 20 nm, de préférence entre 10 nm et 20 nm.

Avantageusement, chaque cavité présente une profondeur comprise entre 1 angström et 200 nm, et de préférence entre 10 nm et 100 nm.

### BREVES DESCRIPTION DES FIGURES

D'autres caractéristiques et avantages de l'invention ressortiront à la lecture de la description détaillée qui suit, en référence aux figures annexées, qui représentent :
- Les figures 1a à 1e, les étapes d'un procédé selon un mode de réalisation de l'invention ;
- Les figures 2c à 2e, des étapes d'un procédé selon un autre mode de réalisation de l'invention ;
- Les figures 3a et 3b, des motifs microstructurés pouvant être utilisés dans un procédé selon un mode de réalisation de l'invention ;
- Les figures 4d et 4e, des étapes alternatives aux étapes représentées sur les figures 1d et 1e ;
- La figure 5a, une représentation schématique d'un substrat selon un mode de réalisation de l'invention ;
- La figure 5b, une vue agrandie de la partie E du substrat de la figure 5a ;
- La figure 6, une courbe représentant la réflectivité d'un substrat selon un mode de réalisation de l'invention pour une longueur d'onde incidente de 785 nm, en fonction de la hauteur H1 des picots métallique de ce substrat, lorsque ces picots métalliques présentent une largeur W1 =40 nm, et que les gaps d'air entre ces picots présentant une profondeur P0=40 nm et une largeur W0=7,3 nm ;
- La figure 7, un diagramme représentant l'évolution de la réflectivité d'un substrat selon un mode de réalisation de l'invention pour une longueur d'onde incidente de 785 nm, en fonction de la largeur W1 des picots métallique de ce substrat et de la largeur WO des cavités entre ces picots métalliques, lorsque ces picots métalliques présentent une hauteur H1=100nm et que les cavité présentent une profondeur P0=40nm ;
- La figure 8, un diagramme représentant l'évolution de la réflectivité d'un substrat selon un mode de réalisation de l'invention pour une longueur d'onde incidente de 785 nm, en fonction de la hauteur H1 des picots métallique de ce substrat et de la hauteur H1-P0 des cavités entre ces picots métalliques, lorsque ces picots métalliques présentent une largeur W1=40nm et que les cavité présentent une largeur W2=7.3 nm ;
- Les figures 9a et 9b, des vues de dessus de substrats selon un premier et un second modes de réalisation de l'invention ;
- Les figures 10a et 10b, des vues de dessus de substrats selon deux autres modes de réalisation de l'invention ;
- La figure 11, une vue de dessus d'un substrat selon un autre mode de réalisation de l'invention ;
- La figure 12, une vue en coupe d'un motif microstructuré d'un substrat selon un mode de réalisation de l'invention ;

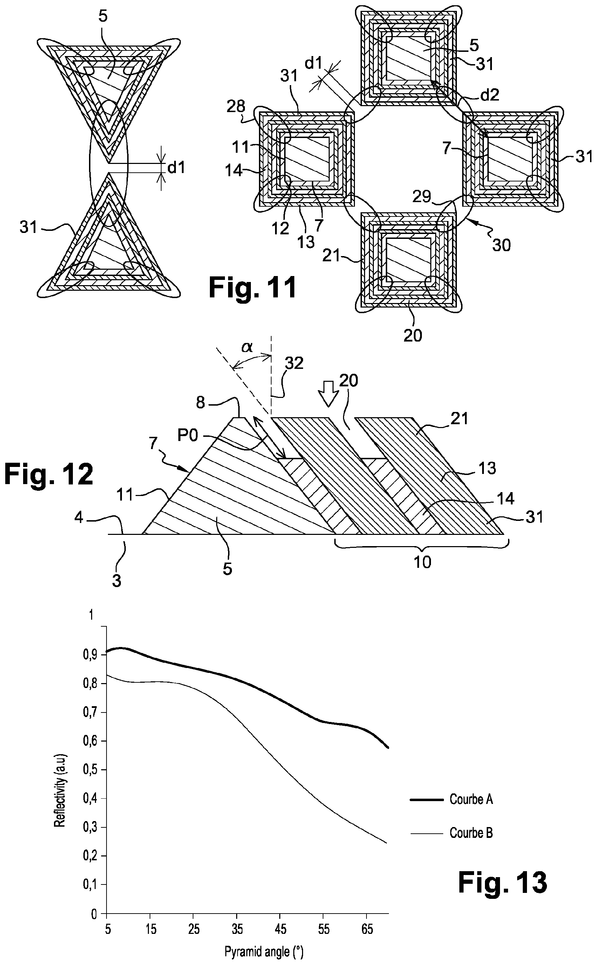

- La figure 13, la courbe de réflectivité résultante d'une onde incidente à 785 nm sur le substrat de la figure 12, en fonction de l'angle α d'inclinaison des parois latérales des motifs microstructurés de ce substrat dans les cas où le motif microstructuré n'est recouvert que par une couche métallique en or (courbe A) et dans le cas où le motif microstructuré est recouvert d'une multicouche comportant deux couches métalliques en or de 40 nm d'épaisseur et deux couches intercalaires en oxyde de silicium de 20 nm d'épaisseur, les cavités entre les picots métalliques présentant une profondeur P0 de 100 nm ;
- Les figures 14a à 14f, des vues d'un substrat selon un mode de réalisation de l'invention pendant un procédé de réalisation de ce substrat ;
- Les figures 15a à 15d, des vues d'un substrat selon un autre mode de réalisation pendant un procédé de réalisation de ce substrat;
- Les figures 16a et 16b, des vues d'un substrat pendant les étapes (102) et (103) d'un procédé selon un mode de réalisation de l'invention ;
- Les figures 16c et 16d, des vues d'un autre substrat pendant les étapes (102) et (103) d'un procédé selon un mode de réalisation de l'invention.

### DESCRIPTION DETAILLEE D'AU MOINS UN MODE DE REALISATION

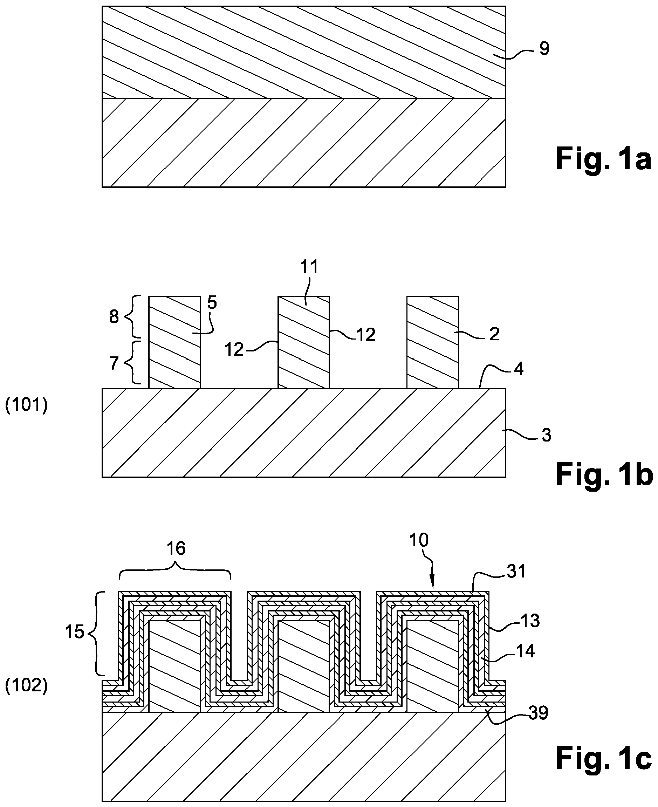

Les figures 1a à 1e représentent les différentes étapes d'un procédé selon un mode de réalisation de l'invention.

Ce procédé comporte une première étape 101 de réalisation d'une structure porteuse 2 non métallique sur une surface supérieure 4 d'un support 3. Selon différents modes de réalisation, le support 3 peut être en silicium, métal, verre.

La structure porteuse 2 comporte au moins un motif microstructuré 5, et de préférence plusieurs motifs microstructurés 5. Chaque motif microstructuré présente de préférence des dimensions comprises entre 50 nm et 100 µm. Chaque motif microstructuré 5 présente une partie supérieure 8, également appelé « sommet » ou « crête » et une paroi latérale 7, également appelée « flanc ». La paroi latérale 7 des motifs microstructurés 5 s'étend de préférence suivant une direction sécante à la surface supérieure 4 du support 3. Les motifs microstructurés 5 peuvent présenter différentes formes.

Ainsi, selon un mode de réalisation représenté sur la figure 1b, chaque motif microstructuré 5 peut présenter une forme de parallélépipède. Dans ce cas, chaque motif microstructuré 5 comporte :
- une paroi supérieure 8 s'étendant suivant une direction sensiblement parallèle à la surface supérieure 4 du support ;
- une paroi latérale 7 s'étendant suivant une direction sensiblement perpendiculaire à la surface supérieure 4 du support 3. La paroi latérale 7 comporte quatre faces 11 séparées entre elles par des arêtes 12.

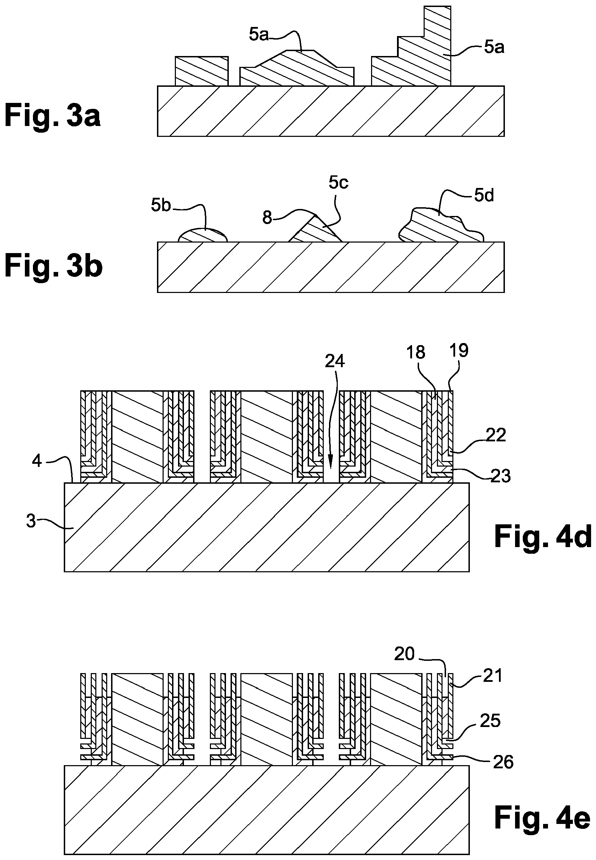

Toutefois, les motifs microstructurés pourraient également présenter d'autres formes. Ainsi en référence à la figure 3a, chaque motif microstructuré 5a pourrait comporter plusieurs parties, présentant des hauteurs différentes les unes des autres. On obtient alors un motif microstructuré qui présente une forme d'escalier. En référence à la figure 3b, chaque motif microstructuré 5b pourrait présenter une forme de dôme, ou encore une forme de triangle, de pyramide, ou encore des formes plus complexes. Selon différents modes de réalisation, les motifs microstructurés de la structure porteuse peuvent tous présenter la même forme, comme représenté sur la figure 1b, ou alors ils peuvent présenter des formes différentes, comme représenté sur les figures 3a et 3b.

La structure porteuse 2 est de préférence constituée de polymères. En effet, les polymères présentent l'avantage de ne pas ou très peu absorber la résonance plasmonique des métaux, de sorte qu'ils ne diminueront pas l'exaltation du champ électromagnétique local. Selon différents modes de réalisation,, la structure porteuse peut être constituée de polymères à base acrylique, de polymères à base de poly hydroxy styrène (PHS) ou de polymères à base de méthyl méthacrylate (MMA). Les bases acryliques permettent d'avoir une meilleur adhérence des couches métalliques à leurs surfaces et une meilleur tenue mécanique pour les étapes ultérieures. En outre, les polymères cités présentent l'avantage de supporter les étapes suivantes du procédé.

La structure porteuse non métallique peut être réalisée grâce à différentes techniques en fonction du matériau qui la constitue. Ainsi, lorsque la structure porteuse est réalisée en polymère, l'étape de réalisation de la structure porteuse peut comporter les sous-étapes suivantes :
- formation d'une couche de polymère 9, par exemple par dépôt à la tournette (ou « spin-coating » en anglais) ;
- formation des motifs microstructurés 5, par exemple par lithographie nanoimpression (ou « nanoimprint lithography » en anglais), photolithographie, lithographie électronique, lithographie dans l'etrème ultraviolet, lithographie interférentielle ou encore par écriture laser.

En référence à la figure 1c, le procédé comporte ensuite une étape 102 de dépôt d'une multicouche 10 sur la structure porteuse 2. La multicouche 10 épouse la forme de la structure porteuse de sorte qu'elle se dépose sur la partie supérieure 8 des motifs microstructurés 5 et sur leur paroi latérale 7. La multicouche 10 comporte donc des parties 15 qui s'étendent suivant une direction sécante à la surface supérieure 4 du support et d'autres parties qui s'étendent suivant une direction sensiblement parallèle à la surface supérieure 4 du substrat.

La multicouche 10 comporte au moins deux couches métalliques 13 de même épaisseur, deux couches métalliques successives 13 étant séparées par une couche intercalaire 14. En effet, les couches métalliques ont une réponse dite « plasmonique » lorsqu'elles sont soumises à une radiation électromagnétique déterminée. Les couches métalliques sont de préférence constituées de l'un des matériaux suivants : or, argent, cuivre, aluminium. Selon différents modes de réalisation, les couches métalliques peuvent être toutes constituées du même matériau, ou alors elles peuvent être constituées au moins deux par deux avec le même matériau. On peut alors avoir différentes paires de couches métalliques dans la multicouches ce qui permettrait de faire fonctionner le dispositif à différentes longueurs d'ondes.. Par ailleurs, les couches métalliques peuvent toutes présenter la même épaisseur ou alors elles peuvent présenter des épaisseurs différentes, ce qui permet d'obtenir un gradient d'indice progressif, tant qu'au moins deux couches métalliques ont la même épaisseur, telle que définie dans les revendications annexées. En effet, en ajustant les épaisseurs de chaque couche, on peut faire varier l'indice optique équivalent de la multicouche entre l'indice optique des couches métalliques et celui des couches intercalaires, tant que la somme de l'épaisseur d'une couche métallique et de l'épaisseur d'une couche intercalaire reste inférieure à la longueur d'onde incidente. Le substrat ainsi formé présentera alors des résonnances à plusieurs longueurs d'onde incidentes.

Les couches intercalaires 14 sont constituées d'un matériau pouvant être gravé sélectivement par rapport aux couches métalliques. Selon différents modes de réalisation, les couches intercalaires peuvent être toutes constituées du même matériau, ou alors elles peuvent être constituées de matériaux différents les uns des autres. Dans ce dernier cas, toutes les couches intercalaires sont de préférence constituées d'un matériau pouvant être gravé sélectivement par rapport aux couches métalliques, soit en même temps ou les unes après les autres avec des procédés différents. Alors on peut envisager d'avoir des profondeurs de cavités différentes et donc d'ajuster le fonctionnement et/ou la résonnance du substrat ainsi obtenu.

Selon un mode de réalisation préférentiel, les couches intercalaires sont constituées d'un matériau diélectrique. En effet, les matériaux diélectriques n'absorbent pas ou peu le plasmon généré à la surface des couches métalliques. On peut par exemple choisir comme matériau diélectrique de l'oxyde de silicium, de l'alumine, de l'oxyde d'hafnium, du nitrure de silicium, de l'oxyde de titane... Par ailleurs, les couches intercalaires peuvent toutes présenter la même épaisseur ou alors elles peuvent présenter des épaisseurs différentes, ce qui permet d'obtenir un gradient d'indice progressif. Le substrat ainsi formé présentera alors des résonnances à plusieurs longueurs d'onde incidentes.

On pourrait également envisager de réaliser les couches intercalaires dans des matériaux métalliques. Toutefois, dans ce cas, la profondeur des cavités creusées dans les couches intercalaires devra être plus importante que dans le mode de réalisation précédent, de façon à ce que la couche intercalaire n'absorbe pas le plasmon généré à la surface des couches métalliques.

Les couches de la multicouche sont de préférence déposées par une méthode de dépôt conforme de sorte que l'épaisseur de la multicouche est sensiblement la même sur toute la surface des motifs microstructurés. On peut pour cela déposer les couches de la multicouche par dépôt physique en phase vapeur, à l'aide d'un faisceau de bombardement incliné, en faisant tourner l'échantillon.

Lors de l'étape de dépôt de la multicouche, la première couche déposée sur les motifs microstructurés, qui sera appelée « couche intérieure » 39, peut être une couche métallique ou alors ce peut être une couche intercalaire. De même, la dernière couche déposée, qui sera appelée « couche extérieure » 31, peut être une couche métallique ou alors ce peut être une couche intercalaire. Le fait d'avoir comme couche extérieure 31 une couche intercalaire permet de protéger la couche métallique active des procédés ultérieurs et/ou des risques de réaction chimique avec l'atmosphère ou de d'endommagement mécanique de type rayures lors de la manipulation du substrat.

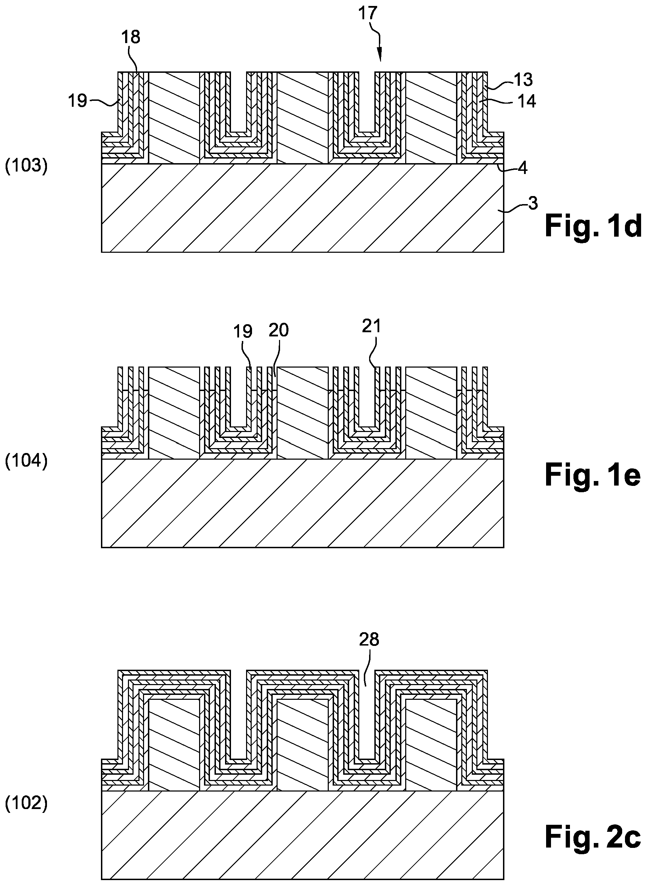

En référence à la figure 1d, le procédé comporte ensuite une étape 103 de gravure d'une partie de la multicouche déposée sur la partie supérieure 8 de chaque motif microstructuré 5. Cette étape est dite «étape d'écrêtage ». En effet, elle comporte une étape de gravure de la partie de la multicouche déposée sur la crête de chacun des motifs microstructurés. Cette étape peut également comporter une étape de gravure d'une partie de la crête de chaque motif microstructuré. Dans le mode de réalisation de la figure 1d, la partie 16 des multicouches déposée sur la surface supérieure 8 des motifs microstructurés est gravée. Pour cela, on peut par exemple graver les régions de la multicouches qui sont parallèles à la surface supérieure 4 du support, tout en gravant moins vite les régions de la multicouche qui sont inclinées par rapport à la surface supérieure 4 du support. Cette étape de gravure 103 est réalisée par polissage mécano chimique (ou CMP pour « Chemical Mechanical Planarization »). Cette technique de gravure permet d'obtenir des arêtes non arrondies et de ne pas modifier l'épaisseur des couches.

On obtient alors à l'issue de cette étape des colonnes 17 s'étendant suivant une direction sécante à la surface supérieure 4 du support 3, chaque colonne 17 comportant une alternance de couches métalliques et de couches intercalaires. Les extrémités supérieures 18 de chaque couche métallique et les extrémités supérieures 19 de chaque couche intercalaire sont exposées à l'air et elles sont donc accessibles pour la suite des étapes du procédé.

Alternativement, en référence à la figure 4d cette étape 103 de gravure des parties de la multicouche disposées sur la partie supérieure 8 des motifs microstructurés peut également comporter une étape de gravure des parties horizontales 24 de la multicouche disposées à la surface 4 du support. On obtient ainsi non seulement un accès aux extrémités supérieures 18 et 19 des couches intercalaires et des couches métalliques, mais également à leurs extrémités inférieures 22 et 23, ce qui sera utile pour réaliser une étape de double gravure, comme on le verra par la suite en référence à la figure 4e.

En référence à la figure 1e, le procédé comporte ensuite une étape 104 de gravure sélective d'une partie des couches intercalaires 14 de façon à former des cavités d'air 20 entre les extrémités 19 de deux couches métalliques 13 successives. Plus précisément, au cours de cette étape, les extrémités 18 des couches intercalaires 14 sont gravées sélectivement par rapport aux extrémités 19 des couches métalliques 13 de façon à ce que, à la fin de cette étape, les extrémités 19 des couches métalliques soient séparées par des cavités d'air 20. Cette étape de gravure est partielle de façon à conserver une partie des couches intercalaires entre les couches métalliques ce qui permet de maintenir les couches métalliques en place sans qu'elles ne s'effondrent les unes sur les autres et aussi d'avoir des cavités d'air de profondeur contrôlée. La technique utilisée pour graver sélectivement les couches intercalaires dépend du matériau choisi pour les couches intercalaires et pour les couches métalliques. Selon différents modes de réalisation, la technique choisie peut être une technique de gravure sèche ou humide.

Alternativement, en référence à la figure 4e, l'étape 104 de gravure sélective peut être une étape de double gravure au cours de laquelle on grave sélectivement les extrémités supérieures 18 des couches intercalaires, mais également les extrémités inférieures 22 des couches intercalaires. On obtient alors deux fois plus de picots métalliques et deux fois plus de cavités : en effet, on obtient comme précédemment des picots métalliques verticaux 21 séparés par des cavités d'air 20 verticaux et des picots métalliques horizontaux 26 séparés par des cavités d'air 25 horizontaux. Comme précédemment, cette étape de double gravure peut être effectuée par gravure sèche ou humide.

Le procédé permet de fabriquer un substrat 40 pouvant être utilisé dans le cadre de la détection Raman exaltée en surface. En effet, on obtient ainsi à la surface du substrat des motifs microstructurés 5 entourés par des picots métalliques 21, 26 de dimensions nanométriques, séparés par des cavités d'air de dimensions également nanométriques. Chaque cavité d'air obtenue à l'issue du procédé présente de préférence une largeur comprise entre 1 angström et 20 nm et une profondeur comprise entre 10 nm et 100 nm. Chaque picot métallique obtenu à l'issue du procédé présente de préférence une largeur comprise entre 10 nm et 50 nm.

Le procédé peut ensuite comporter une étape de dépôt de molécules d'intérêt à la surface du substrat ainsi obtenu. Les molécules d'intérêt se déposent alors à la surface des picots métalliques et dans les cavités d'air. Les matériaux choisis pour réaliser la structure porteuse peuvent être choisis en fonction de leur énergie de surface, de façon à contrôler le dépôt des molécules qui seront ensuite déposées sur le substrat. On peut ainsi favoriser le dépôt des molécules à certains endroits du substrat plutôt qu'à d'autres endroits.

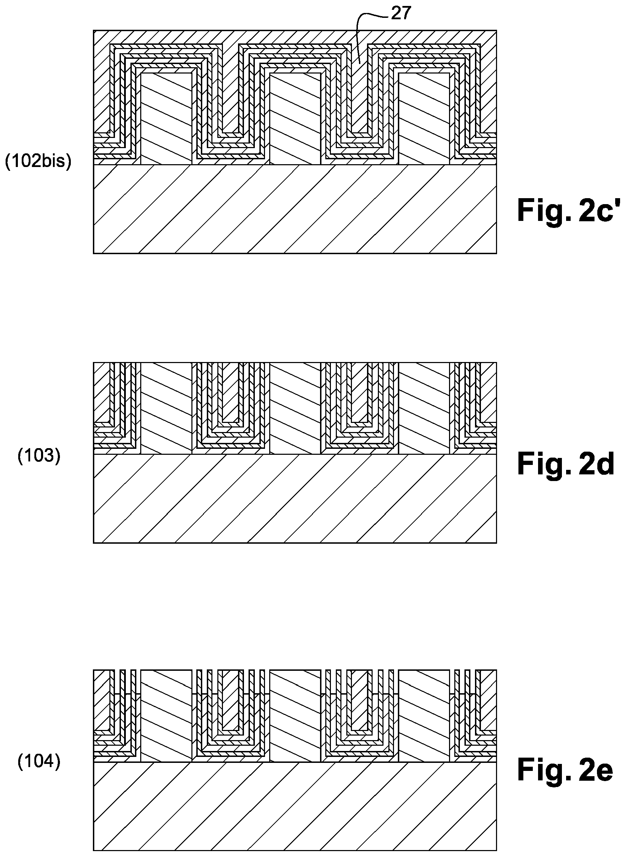

L'invention n'est pas limitée au mode de réalisation décrit ci-dessus. Ainsi, comme représenté sur les figures 2c à 2e, le procédé décrit en référence aux figures 1a à 1e pourrait également comporter, suite à l'étape 102 de dépôt de la multicouche 10, une étape additionnelle 102bis de dépôt d'un matériau diélectrique 27 dans les espaces 28 formés entre les motifs microstructurés 5 recouverts par la multicouche 10. Ce matériau diélectrique 27 permet de remplir l'espace vide entre les motifs microstructurés ce qui rend plus aisée et plus contrôlable l'étape d'écrêtage par polissage mécano chimique. Par ailleurs comme cet espace vide est rempli les résidus formés pendant l'étape d'écrêtage ne vont pas se loger dans les espaces vides et pourront être par la suite aisément retirés par des procédés de nettoyage de la surface.

Dans le cas contraire le retrait de ces résidus peut s'avérer impossible ou très compliqué et ces derniers pourraient perturber le bon fonctionnement du substrat. Le matériau diélectrique 27 déposé dans les espaces 28 peut être par exemple de l'oxyde de silicium ou du nitrure de silicium. Les étapes ultérieures 103, 104 du procédé sont identiques à celles décrites précédemment.

Le procédé selon l'invention est particulièrement avantageux puisqu'il permet d'obtenir des picots métalliques séparés par des cavités de dimensions précisément contrôlables. En effet, la largeur w1 des picots métalliques 21 obtenus est contrôlée en contrôlant l'épaisseur des couches métalliques 13 déposées. De même, la largeur w0 des cavités 20 d'air est contrôlée en contrôlant l'épaisseur des couches intercalaires 14 déposées. La largeur des picots et des cavités et donc facilement et précisément contrôlable puisque l'épaisseur des couches déposées l'est aussi. Par ailleurs, la profondeur P0 des cavités d'air est contrôlable en contrôlant la gravure de l'extrémité des couches intercalaires 20 qui elle aussi est facilement contrôlable. En outre, lorsque la couche intercalaire est en matériau diélectrique, le procédé n'utilise pas d'étape de gravure agressive puisque ladite couche intercalaire peut être facilement gravée par gravure sèche ou chimique.

### Dimensionnement des picots métalliques et des cavités:

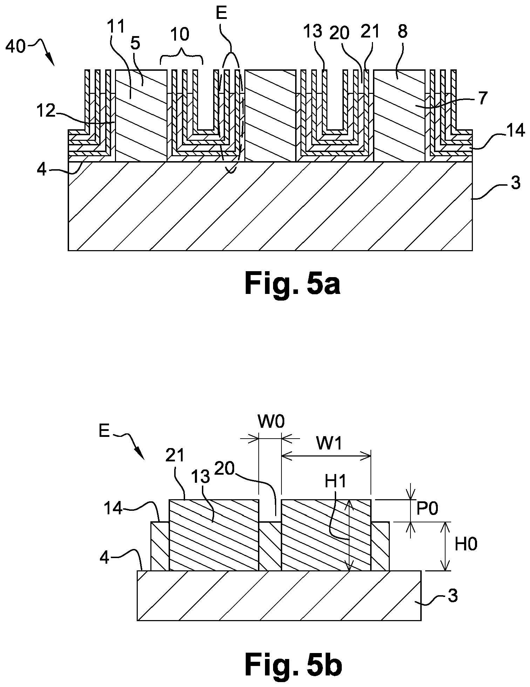

Un procédé de dimensionnement des picots métalliques 21 et des cavités 20 qui les séparent va maintenant être décrit en référence aux figures 5a et 5b.

Les dimensions choisies pour les picots et les cavités sont primordiales pour obtenir une résonnance du champ électromagnétique. Ces dimensions peuvent être déterminées selon la méthode expliquée ci-après.

On choisit d'abord la longueur d'onde incidente de la lumière monochromatique qui sera envoyée sur les molécules à détecter. Cette longueur d'onde incidente peut être choisie en fonction des molécules à détecter et/ou en fonction du matériel à la disposition de l'utilisateur. Dans ce mode de réalisation, on choisit par exemple une longueur d'onde incidente de 785 nm.

On choisit ensuite les matériaux qui vont constituer les couches métalliques et les couches intercalaires de la multicouche 10. Ces matériaux peuvent être choisis en fonction des procédés de dépôt disponibles, et/ou pour des raisons d'affinités chimiques avec les molécules à détecter, et/ou en fonction des propriétés d'absorption de ces matériaux vis-à-vis de la longueur d'onde incidente. Dans ce mode de réalisation, on choisit par exemple de réaliser des couches métalliques en or et des couches intercalaires en SiO₂.

Le procédé comporte ensuite une étape de dimensionnement des cavités 20 et des picots métalliques 21 en fonction de la longueur d'onde incidente choisie et des matériaux choisis pour la multicouche. En effet, il est possible de déterminer les dimensions des picots et des cavités de façon à ce que le substrat présente une résonnance à la longueur d'onde incidente. Pour cela, on détermine les dimensions des cavités 20 et des picots 21 qui minimisent la réflectivité du substrat et donc qui maximisent le renforcement du champ électromagnétique. On peut par exemple utiliser pour cela une méthode dite « d'analyse rigoureuse des ondes couplées » (ou RCWA pour « rigourous coupled wave analysis) ou une méthode dite de « domaine temporel des différences finies » (ou FDTD pour « finite différence time domain »). Ces méthodes permettent de simuler la réflectivité d'une surface en fonction de sa géométrie et de sa composition.

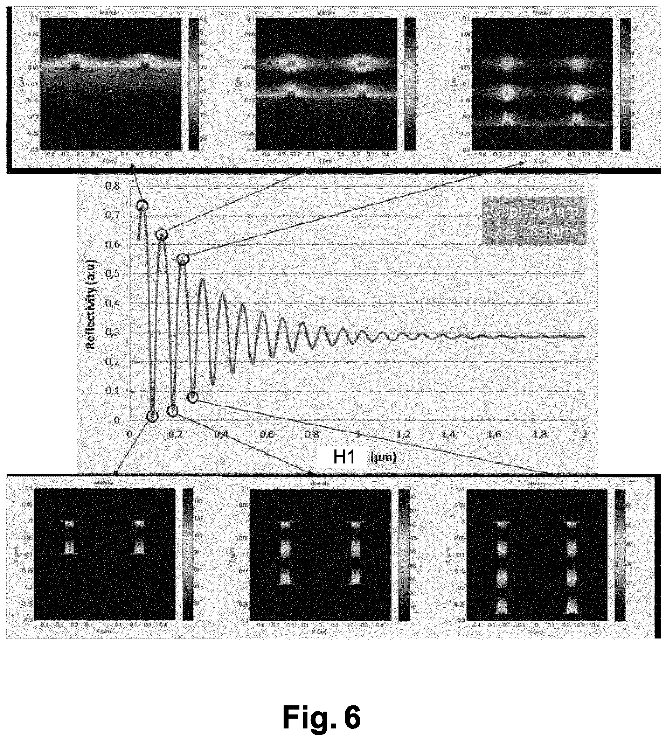

Ainsi, la figure 6 représente ainsi l'évolution, en fonction de la hauteur H1 des picots métalliques, de la réflectivité d'une structure comportant une alternance de couches en or et en silice pour une longueur d'onde incidente de 785 nm, lorsque les picots métalliques présentent une largeur W1 =40 nm, que les cavités présentent une largeur W0 de 7,3 nm et une profondeur P0 de 40 nm. On voit alors que la structure obtenue peut présenter un minimum de réflectivité pour une hauteur H1 égale à 99 nm ou 187 nm, ou 275 nm... On peut donc choisir une de ces hauteurs pour les picots métalliques H1.

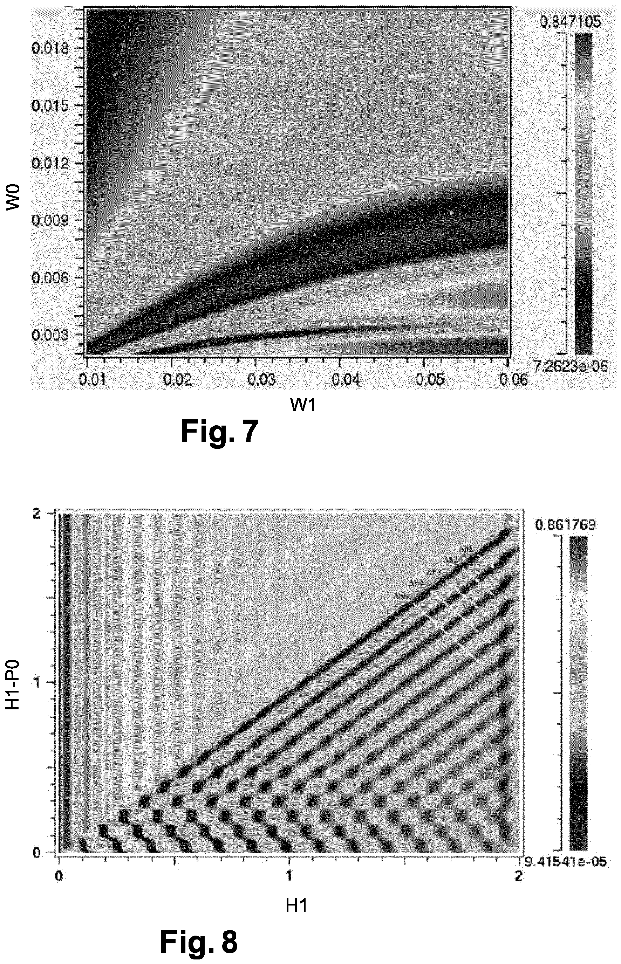

La figure 7 représente une autre simulation effectuée par une méthode d'analyse rigoureuse des ondes couplées » (ou RCWA pour « rigourous coupled wave analysis) dans laquelle :
- la longueur d'onde incidente est fixée à 785 nm,
- les couches métalliques sont constituées d'or,
- les couches intercalaires sont constituées de silice,
- la hauteur H1 des picots est fixée à 100 nm ;
- la profondeur P0 des cavités est fixée à 40 nm.

On regarde cette fois l'évolution de la réflectivité du substrat en fonction de la largeur W1 des picots et de la largeur W0 des cavités. On constate que le minimum de réflectivité est atteint lorsque W1 et W0 respectent la loi logarithmique suivante : WO=439 In(W1)-1909, avec W1 et W0 en microns.

La figure 8 représente une autre simulation effectuée dans laquelle on a cette fois fixé les largeurs W1 des picots et celles W0 des cavités et on cherche les hauteurs optimales de façon à avoir le minimum de réflectivité. Ainsi, cette simulation a été effectuée par une méthode d'analyse rigoureuse des ondes couplées » (ou RCWA pour « rigourous coupled wave analysis) dans laquelle :
- la longueur d'onde incidente est fixée à 785 nm,
- les couches métalliques sont constituées d'or,
- les couches intercalaires sont constituées de silice,
- la largeur des picots est fixée à 40 nm ;
- la largeur des cavités est fixée à 7.3 nm.

Ces simulations permettent donc de déterminer :
- la largeur W1 des picots et donc l'épaisseur des couches métalliques déposées ;
- la largeur W0 des cavités et donc l'épaisseur des couches intercalaires déposées ;
- la hauteur H1 des picots et donc la hauteur des motifs microstructurés à l'issue de l'étape 103 ;
- la profondeur P0 des cavités et donc la durée de gravure de l'extrémité des couches intercalaires.

Des simulations peuvent également être effectuées pour déterminer le nombre de couches dans la multicouche. Ces simulations sont identiques à celles présentées précédemment sauf qu'au lieu de ne prendre en considération que deux couches métalliques et une couche intercalaire, on prend en considération un plus grand nombre de couches de façon à identifier ou non des modes de couplages entre les différentes répétitions de couches, ce qui pourrait ou non modifier un peu les géométries optimales. On en déduit ainsi l'épaisseur optimale de la multicouche 10.

### Choix de la structure porteuse :

Le procédé comporte ensuite une étape de détermination de la structure porteuse.

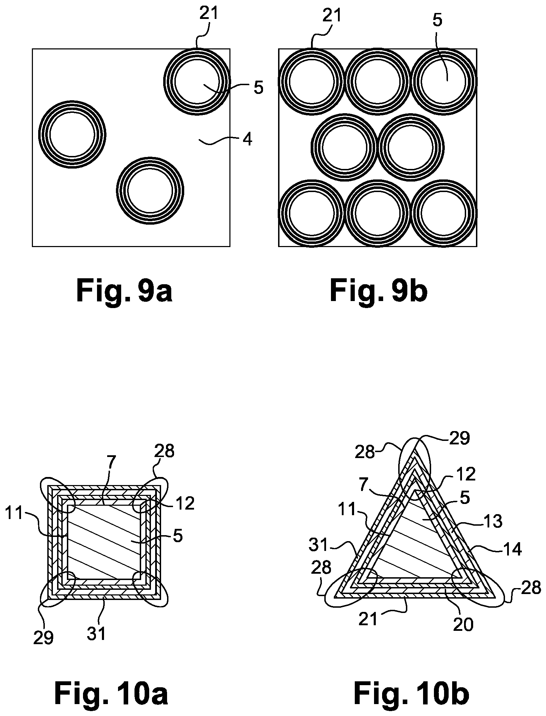

La structure porteuse comporte de préférence plusieurs motifs microstructurés 5 sur lesquels sera déposée la multicouche. Ces motifs microstructurés 5 peuvent être isolés les uns des autres comme représenté sur la figure 9a ou alors ils peuvent former un réseau comme représenté sur la figure 9b. Le fait d'avoir des motifs microstructurés qui forment un réseau permet d'avoir une plus grande densité de points chauds.

La forme de chaque motif microstructuré 5 peut également être déterminée en simulant la réponse qu'aura le substrat en fonction de la forme choisie. Ces simulations peuvent également être effectuées avec une méthode d'analyse rigoureuse des ondes couplées ou une méthode de domaine temporel des différences finies. Ainsi, en référence aux figures 10a et 10b, la forme des parois latérales 7 des motifs microstructurés 5 est de préférence choisie de façon à ce que les parois latérales 7 comportent des faces 11 séparées entre elles par des arêtes 12. L'angle de ces arêtes 12 est déterminé de façon à ce que la structure porteuse, une fois recouverte par la multicouche 10, génère un renforcement du champ électromagnétique par effet de pointe dans des zones 28 situées à proximité des arêtes 12. Plus précisément, la couche métallique extérieure 31 de la multicouche qui recouvre les motifs microstructurés forme également des arêtes 29 là où la paroi latérale 7 des motifs microstructurés forme des arêtes 12. Les arêtes 29 de la couche métallique extérieure 31 génèrent donc des effets de pointes et donc des zones 28 de renforcement du champ électromagnétique.

Par ailleurs, en référence à la figure 11, l'écartement entre deux motifs microstructurés adjacents peut également être déterminé, par des simulations avec des logiciels de calcul électromagnétique, de façon à optimiser les effets de couplage entre des motifs microstructurés adjacents de façon à augmenter le renforcement du champ électromagnétique. Plus précisément, en optimisant la distance entre les arêtes 29 de la couche métallique extérieure 31 entourant deux motifs microstructurés adjacents, on peut encore optimiser le renforcement du champ électromagnétique en couplant l'effet de pointe généré par les arêtes 29 et le confinement du champ électromagnétique créé dans l'espace 30 formé entre ces deux arêtes 29. Cette optimisation de la distance d1 entre les arêtes 29 de la couche métallique extérieure 31 est de préférence effectuée grâce à un logiciel de calcul électromagnétique. Cette distance d1 est de préférence comprise entre 1 nm et 50 nm. Une fois la distance d1 fixée, comme l'épaisseur de la multicouche 10 a été fixée précédemment au cours de l'étape de dimensionnement des cavités et des picots, on en déduit la distance d2 entre les arêtes 12 de deux motifs microstructurés adjacents 5.

En référence à la figure 12, l'angle α formé entre les parois latérales 7 de chaque motif microstructuré 5 et un axe de référence 32 perpendiculaire à la surface supérieure 4 du support peut également être optimisé de façon à minimiser la réflectivité du substrat ainsi formé. Ainsi, la figure 13 représente l'évolution de la réflectivité résultante d'une onde incidente à 785 nm en fonction de l'angle α :
- d'un motif microstructuré 5 en forme de pyramide recouvert par une couche d'or de 160 nm (courbe A) ;
- d'un motif microstructuré 5 en forme de pyramide recouvert par une multicouche 10 comportant
   ∘ deux empilements comportant chacun :
      ▪ une couche métallique 13 en or de 40 nm;
      ▪ une couche intercalaire 14 en oxyde de silicium de 20 nm d'épaisseur ;
   ∘ une couche métallique en or de 40 nm d'épaisseur.
   Les cavités 20 formés entre deux picots métalliques 21 successifs présentant chacun une profondeur P0 de 100 nm (courbe B).

On constate sur cette figure que plus l'angle α augmente, plus la réflectivité du substrat diminue. En effet, les motifs microstructurés qui ont des parois latérales inclinées par rapport à la normale au plan du support présentent l'avantage, qu'après gravure sélective de l'extrémité des couches intercalaires par rapport aux extrémités des couches métalliques, les cavités formés présentent des ouvertures non parallèles à la surface 4 du support 3 ce qui permet une utilisation optimum du substrat si l'onde monochromatique incidente n'est pas émise suivant une direction normale à la surface supérieure du support. En effet, le couplage entre l'onde incidente et chaque cavité dépend fortement de l'angle entre l'ouverture du cavité et la direction de l'onde monochromatique. La réflectivité diminue lorsque l'angle de la pyramide s'accentue. Ce phénomène est d'autant plus marqué pour les structures avec des cavités.

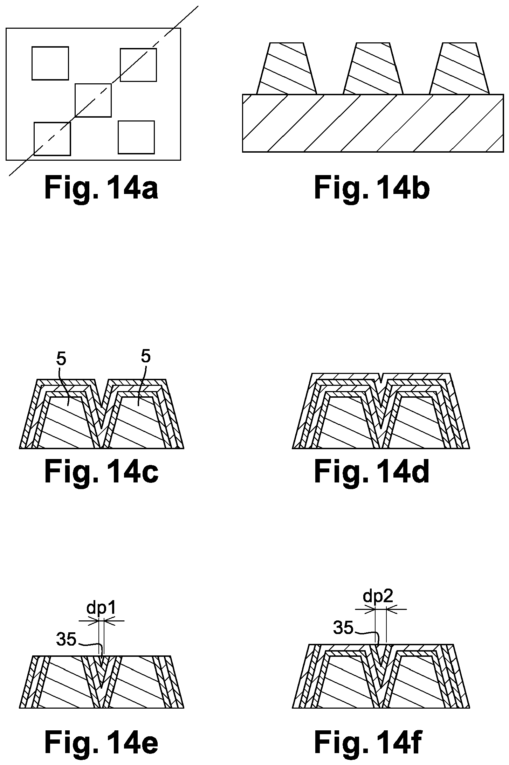

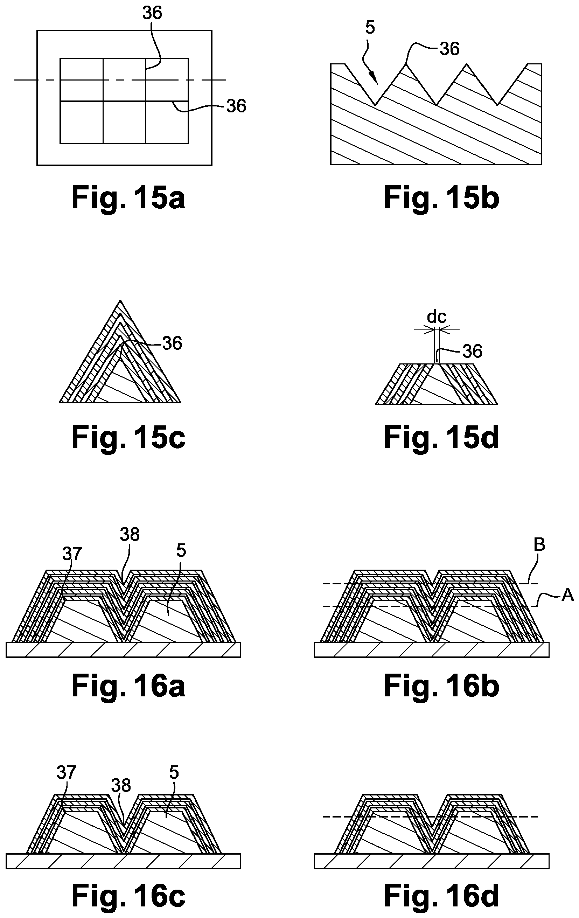

On peut également choisir de réaliser une structure porteuse faisant saillie de la surface du support comme représenté sur les figures 14a à 14f, ou alors on peut choisir de réaliser une structure porteuse creusée dans le support ou dans une couche déposée sur le support, comme représenté sur les figures 15a à 15d. Dans le cas d'une structure porteuse en saillie, des points chauds sont créés par les gaps 35 formés entre les multicouches déposées sur deux motifs microstructurés 5 adjacents comme représenté sur les figures 14e et 14f. La distance dp1 entre ces multicouches peut être calculée de façon à optimiser l'amplification du champ électromagnétique dans cette zone. Dans le cas d'une structure porteuse creusée, des points chauds sont créés par effet de pointe au niveau de l'extrémité supérieure 36 des arêtes séparant deux motifs microstructurés 5 adjacents. La largeur dc de cette arête 36 est également calculée de façon à optimiser l'amplification du champ électromagnétique obtenue.

### Dimensionnement de la structure porteuse :

Les dimensions de la structure porteuse non métallique ainsi que les matériaux la constituant peuvent être choisis de façon à ce que la structure porteuse forme un cristal photonique. Ce cristal photonique permettra de renforcer le couplage optique entre la surface de l'échantillon (avec les nano gaps) et le laser incident. Dans la pratique le cristal photonique peut être dimensionné avec un logiciel de calcul et il permet au laser incident arrivent sur la surface en incidence quasi normale d'être redirigé dans le plan du substrat ce qui permet d'accroitre considérablement la longueur d'interaction entre le laser incident et nos nangaps.

### Dimensionnement des motifs microstructurés :

Une fois la forme de la structure porteuse déterminée, le procédé comporte une étape de détermination des dimensions des motifs microstructurés de la structure porteuse. Le choix de ces dimensions ne nécessite pas obligatoirement un calcul de renforcement des ondes électromagnétiques, en dehors de la hauteur de ces motifs qui est déterminée de façon à avoir la hauteur H1 voulue pour les picots métalliques. Les autres dimensions des motifs microstructurés sont de préférence déterminées en fonction de :
- la capacité technologique des procédés utilisés pour réaliser ces motifs lors de l'étape 101 ;
- la capacité technologique des procédés de gravure utilisés lors de l'étape 103 ;
- la capacité technologique des procédés de dépôt pour leur aptitude à planariser une structure existante si l'épaisseur déposée est trop importante. En effet, si les motifs microstructurés sont trop hauts ; il est plus compliquer d'avoir un dépôt conforme sur toute la hauteur de de chaque motif car chaque étape de dépôt, notamment si elle est réalisée par PVD ou évaporation, n'est pas parfaitement conforme et il y a une légère déformation de la forme de la structure résultante après chaque dépôt et donc au fur et à mesure du dépôt il peut y avoir une planarisation de la structure ce qui n'est pas recherché.

Par ailleurs, en référence aux figures 16c et 16d, la hauteur des motifs microstructurés 5 est de préférence choisie de telle sorte qu'après dépôt de la multicouche le point le plus haut 37 de la première couche déposée sera plus haut que le point le plus bas 38 de la dernière couche déposée. Ainsi, après l'étape d'écrêtage, toutes les couches de la multicouche seront mises à jour. Dans le cas contraire, représenté sur les figures 16a et 16b, une partie des couches de la multicouche ne sera pas utilisable pour la fabrication des cavités, puisque :
- soit elles seront complètement supprimées lors de l'étape d'écrêtage. C'est le cas si l'écrêtage se fait suivant la ligne A ;
- soit elles ne seront pas du tout utilisées car complètement recouvertes par d'autres couches. C'est le cas si l'écrêtage se fait suivant la ligne B.

Naturellement, l'invention n'est pas limitée aux modes de réalisation décrits en référence aux figures et des variantes pourraient être envisagées sans sortir du cadre de l'invention, qui est définie par les revendications annexées.

## Revendications

1. Procédé de fabrication d'un substrat (40) pour diffusion Raman exaltée de surface, le procédé comportant les étapes suivantes :
- (a) réalisation d'une structure porteuse (2) non métallique sur une surface supérieure (4) d'un support (3), la structure porteuse (2) comportant au moins un motif microstructuré (5), le motif microstructuré (5) comportant un sommet (8) et des parois latérales (7), les parois latérales (7) s'étendant suivant une direction sécante à la direction de la surface supérieure (4);
- (b) dépôt d'une multicouche (10) sur la structure porteuse (2), la multicouche (10) comportant au moins deux couches métalliques (13) de même épaisseur et une couche intercalaire (14) disposée entre les deux couches métalliques (13), chaque couche intercalaire (14) étant réalisée dans un matériau pouvant être gravé sélectivement par rapport aux couches métalliques (13);
- (c) gravure par polissage mécano chimique d'une partie de la multicouche (10) déposée sur le sommet (8) du motif microstructuré (5) de façon à exposer des extrémités (18, 19) de chaque couche (13, 14) de la multicouche (10);
- (d) gravure sélective des extrémités (18) des couches intercalaires (14) de façon à former des cavités (20) entre les extrémités (19) de deux couches métalliques (13) successives.

2. Procédé selon la revendication précédente, dans lequel la couche intercalaire (14) est une couche diélectrique.

3. Procédé selon l'une des revendications précédentes, dans lequel chaque motif microstructuré (5) présente une hauteur comprise entre 50 nm et 100 µm.

4. Procédé selon l'une des revendications précédentes, dans lequel la multicouche (10) présente une épaisseur inférieure à la hauteur du motif microstructuré.

5. Procédé selon l'une des revendications précédentes, dans lequel les couches (13, 14) de la multicouche (10) sont déposées suivant une technique de dépôt conforme.

6. Procédé selon l'une des revendications précédentes, dans lequel les parois latérales (7) du motif microstructuré (5) s'étendent suivant une direction qui forme un angle (a) strictement inférieur à 90° avec une direction normale à la surface supérieure du support.

7. Substrat (40) pour diffusion Raman exaltée de surface comportant :
- un support (3) comportant une surface supérieure (4);
- une structure porteuse (2) non métallique disposée sur la surface supérieure (4) du support (3), la structure porteuse (2) comportant au moins un motif microstructuré (5), le motif microstructuré (5) comportant un sommet (8) et des parois latérales (7), les parois latérales (7) s'étendant suivant une direction sécante à la direction de la surface supérieure ;
- une multicouche (10) disposée sur les parois latérales (7) du motif microstructuré (5), la multicouche (10) comportant au moins deux couches métalliques (13) de même épaisseur et une couche intercalaire (14) disposée entre les deux couches métalliques (13), la couche intercalaire (14) étant réalisée dans un matériau pouvant être gravé sélectivement par rapport aux couches métalliques (13), la couche intercalaire (14) présentant une extrémité (18) en retrait par rapport à l'extrémité (19) des couches métalliques (13) qui l'entourent de sorte que les extrémités (19) de deux couches métalliques successives forment des picots métalliques séparés par un cavité (20).

8. Substrat (40) selon la revendication précédente, dans lequel la couche intercalaire (14) est une couche diélectrique.

9. Substrat (40) selon l'une des revendications 7 ou 8, dans lequel la paroi latérale (7) du motif microstructuré (5) comporte des faces (11) séparées par des arêtes (12).

10. Substrat (40) selon l'une des revendications 7 à 9, dans lequel la structure porteuse (2) comporte plusieurs motifs microstructurés (5) formant un réseau périodique.

11. Substrat (40) selon l'une des revendications 7 à 10, dans lequel la multicouche (10) comporte plusieurs couches intercalaires (14), les couches intercalaires (14) présentant des épaisseurs différentes les unes des autres.

12. Substrat (40) selon l'une des revendications 7 à 11, dans lequel chaque motif microstructuré (5) présente une hauteur comprise entre 50 nm et 100 µm.

13. Substrat (40) selon l'une des revendications 7 à 12, dans lequel chaque couche métallique (13) présente une épaisseur comprise entre 1 angström et 50 nm, de préférence entre 10 nm et 50 nm.

14. Substrat (40) selon l'une des revendications 7 à 13, dans lequel chaque couche intercalaire (14) de la multicouche présente une épaisseur comprise entre 1 angström et 20 nm, de préférence entre 10 nm et 20 nm.

15. Substrat (40) selon l'une des revendications 7 à 14, dans lequel chaque cavité présente une profondeur comprise entre 1 angström et 200 nm, et de préférence entre 10 nm et 100 nm.

## Patentansprüche

1. Herstellungsverfahren eines Substrats (40) zur erhöhten Raman-Oberflächendiffusion, wobei das Verfahren die folgenden Schritte umfasst:
- (a) Realisierung einer nicht metallischen Trägerstruktur (2) auf einer oberen Oberfläche (4) eines Trägers (3), wobei die Trägerstruktur (2) wenigstens ein mikrostrukturiertes Muster (5) umfasst, wobei das mikrokstrukturierte Muster (5) eine Spitze (8) und Seitenwände (7) umfasst, wobei die Seitenwände (7) sich gemäß einer die Richtung der oberen Oberfläche (4) schneidenden Richtung erstrecken;
- (b) Aufbringen einer Mehrfachschicht (10) auf der Trägerstruktur (2), wobei die Mehrfachschicht (10) wenigstens zwei Metallschichten (13) derselben Dicke und eine zwischengeschobene Schicht (14) umfasst, die zwischen den zwei Metallschichten (13) angeordnet ist, wobei jede zwischengeschobene Schicht (14) aus einem Material realisiert wird, das selektiv in Bezug auf die Metallschichten (13) geätzt werden kann;
- (c) Gravur per mechanisch-chemischem Polieren eines Teils der Mehrfachschicht (10), der auf der Spitze (8) des mikrostrukturierten Musters (5) derart aufgebracht wird, dass Enden (18, 19) jeder Schicht (13, 14) der Mehrfachschicht (10) freigelegt wird;
- (d) selektive Gravur der Enden (18) der zwischengeschobenen Schichten (14) derart, dass Vertiefungen (20) zwischen den Enden (19) von zwei sukzessiven Metallschichten (13) gebildet werden.

2. Verfahren gemäß dem voranstehenden Anspruch, bei dem die zwischengeschobene Schicht (14) eine dielektrische Schicht ist.

3. Verfahren gemäß einem der voranstehenden Ansprüche, bei dem jedes mikrostrukturierte Muster (5) eine zwischen 50 nm und 100 µm inbegriffene Höhe aufweist.

4. Verfahren gemäß einem der voranstehenden Ansprüche, bei dem die Mehrfachschicht (10) eine geringere Dicke als die Höhe des mikrostrukturierten Musters aufweist.

5. Verfahren gemäß einem der voranstehenden Ansprüche, bei dem die Schichten (13, 14) der Mehrfachschicht (10) gemäß einer konformen Aufbringtechnik aufgebracht werden.

6. Verfahren gemäß einem der voranstehenden Ansprüche, bei dem die Seitenwände (7) des mikrostrukturierten Musters (5) sich gemäß einer Richtung, die einen Winkel (a) bildet, der strikt unter 90° beträgt, mit einer zur oberen Oberfläche des Trägers normalen Richtung erstrecken.

7. Substrat (40) zur erhöhten Raman-Oberflächendiffusion, umfassend:
- einen Träger (3), der eine obere Oberfläche (4) umfasst;
- eine nicht metallische Trägerstruktur (2), die auf der oberen Oberfläche (4) des Trägers (3) angeordnet ist, wobei die Trägerstruktur (2) wenigstens ein mikrostrukturiertes Muster (5) umfasst, wobei das mikrostrukturierte Muster (5) eine Spitze (8) und Seitenwände (7) umfasst, wobei sich die Seitenwände (7) gemäß einer die Richtung der oberen Oberfläche schneidenden Richtung erstrecken;
- eine Mehrfachschicht (10), die auf den Seitenwänden (7) des mikrostrukturierten Musters (5) angeordnet ist, wobei die Mehrfachschicht (10) wenigstens zwei Metallschichten (13) derselben Dicke und eine zwischengeschobene Schicht (14) umfasst, die zwischen den zwei Metallschichten (13) angeordnet ist, wobei die zwischengeschobene Schicht (14) aus einem Material realisiert wird, das in Bezug auf die Metallschichten (13) selektiv geätzt werden kann, wobei die zwischengeschobene Schicht (14) ein Ende (18) aufweist, das in Bezug auf das Ende (19) der Metallschichten (13), die es umgeben, derart zurückgesetzt ist, dass die Enden (19) von zwei sukzessiven Metallschichten durch eine Vertiefung (20) getrennte Metallzähnchen bilden.

8. Substrat (40) gemäß dem voranstehenden Anspruch, bei dem die zwischengeschobene Schicht (14) eine dielektrische Schicht ist.

9. Substrat (40) gemäß einem der Ansprüche 7 oder 8, bei dem die Seitenwand (7) des mikrostrukturierten Musters (5) durch Kanten (12) getrennte Seiten (11) umfasst.

10. Substrat (40) gemäß einem der Ansprüche 7 bis 9, bei dem die Trägerstruktur (2) mehrere mikrostrukturierte Muster (5) umfasst, die ein periodisches Netz bilden.

11. Substrat (40) gemäß einem der Ansprüche 7 bis 10, bei dem die Mehrfachschicht (10) mehrere zwischengeschobene Schichten (14) umfasst, wobei die zwischengeschobenen Schichten (14) voneinander unterschiedliche Dicken aufweisen.

12. Substrat (40) gemäß einem der Ansprüche 7 bis 11, bei dem jedes mikrostrukturierte Muster (5) eine zwischen 50 nm und 100 µm inbegriffene Höhe aufweist.

13. Substrat (40) gemäß einem der Ansprüche 7 bis 12, bei dem jede Metallschicht (13) eine zwischen 1 Angström und 50 nm, bevorzugt zwischen 10 nm und 50 nm, inbegriffene Dicke aufweist.

14. Substrat (40) gemäß einem der Ansprüche 7 bis 13, bei dem jede zwischengeschobene Schicht (14) der Mehrfachschicht eine zwischen 1 Angström und 20 nm, bevorzugt zwischen 10 nm und 20 nm inbegriffene Schicht umfasst.

15. Substrat (40) gemäß einem der Ansprüche 7 bis 14, bei dem jede Vertiefung eine zwischen 1 Angström und 200 nm, und bevorzugt zwischen 10 nm und 100 nm inbegriffene Tiefe aufweist.

## Claims

1. Method for manufacturing a substrate (40) for surface-enhanced Raman spectography, with the method comprising the following steps:
- (a) creating a non-metal supporting structure (2) on an upper surface (4) of a support (3), with the supporting structure (2) comprising at least one microstructured pattern (5), the microstructured pattern (5) comprising a top (8) and sidewalls (7), with the sidewalls (7) extending according to a direction secant to the direction of the upper surface (4);
- (b) depositing of a multilayer (10) on the supporting structure (2), with the multilayer (10) comprising at least two metal layers (13) of the same thickness and an intermediate layer (14) arranged between the two metal layers (13), with each intermediate layer (14) being carried out in a material that can be selectively etched with respect to the metal layers (13);
- (c) etching via chemical mechanical planarisation of a portion of the multilayer (10) deposited on the top (8) of the microstructured pattern (5) in such a way as to expose ends (18, 19) of each layer (13, 14) of the multilayer (10);
- (d) selective etching of the ends (18) of the intermediate layers (14) in such a way as to form cavities (20) between the ends (19) of two successive metal layers (13).

2. Method as claimed in the preceding claim, wherein the intermediate layer (14) is a dielectric layer.

3. Method according to one of the preceding claims, wherein each microstructured pattern (5) has a height between 50 nm and 100 µm.

4. Method according to one of the preceding claims, wherein the multilayer (10) has a thickness less than the height of the microstructured pattern.

5. Method according to one of the preceding claims, wherein the layers (13, 14) of the multilayer (10) are deposited according to a compliant depositing technique.

6. Method according to one of the preceding claims, wherein the sidewalls (7) of the microstructured pattern (5) extend according to a direction that forms an angle (α) that is strictly less than 90° with a direction normal to the upper surface of the support.

7. Substrate (40) for surface-enhanced Raman spectography comprising:
- a support (3) comprising an upper surface (4);
- a non-metal supporting structure (2) arranged on the upper surface (4) of the support (3), with the supporting structure (2) comprising at least one microstructured pattern (5), the microstructured pattern (5) comprising a top (8) and sidewalls (7), with the sidewalls (7) extending according to a direction secant to the direction of the upper surface;
- a multilayer (10) arranged on the sidewalls (7) of the microstructured pattern (5), with the multilayer (10) comprising at least two metal layers (13) of the same thickness and an intermediate layer (14) arranged between the two metal layers (13), with the intermediate layer (14) being made from a material that can be selectively etched with respect to the metal layers (13), with the intermediate layer (14) having an end (18) that is set back with respect to the end (19) of the metal layers (13) that surround it in such a way that the ends (19) of two successive metal layers form metal pins separated by a cavity (20).

8. Substrate (40) as claimed in the preceding claim, wherein the intermediate layer (14) is a dielectric layer.

9. Substrate (40) according to one of claims 7 or 8, wherein the sidewall (7) of the microstructured pattern (5) comprises faces (11) separated by edges (12) .

10. Substrate (40) according to one of claims 7 to 9, wherein the supporting structure (2) comprises several microstructured patterns (5) forming a periodic array.

11. Substrate (40) according to one of claims 7 to 10, wherein the multilayer (10) comprises several intermediate layers (14), with the intermediate layers (14) having thicknesses that differ from one another.

12. Substrate (40) according to one of claims 7 to 11, wherein each microstructured pattern (5) has a height between 50 nm and 100 µm.

13. Substrate (40) according to one of claims 7 to 12, wherein each metal layer (13) has a thickness between 1 angstrom and 50 nm, preferably between 10 nm and 50 nm.

14. Substrate (40) according to one of claims 7 to 13, wherein each intermediate layer (14) of the multilayer has a thickness between 1 angstrom and 20 nm, preferably between 10 nm and 20 nm.

15. Substrate (40) according to one of claims 7 to 14, wherein each cavity has a depth between 1 angstrom and 200 nm, and preferably between 10 nm and 100 nm.
